(19) Europäisches Patentamt
European Patent Office
Office européen des brevets

(11) **EP 3 999 864 B1**

(12) **FASCICULE DE BREVET EUROPEEN**

(45) Date de publication et mention de la délivrance du brevet:
**28.08.2024 Bulletin 2024/35**

(21) Numéro de dépôt: **20739676.3**

(22) Date de dépôt: **10.07.2020**

(51) Classification Internationale des Brevets (IPC):
*G01R 31/388* (2019.01)   *G01R 31/396* (2019.01)

(52) Classification Coopérative des Brevets (CPC):
**G01R 31/396; G01R 31/388;** Y02E 60/10

(86) Numéro de dépôt international:
**PCT/EP2020/069677**

(87) Numéro de publication internationale:
**WO 2021/009086 (21.01.2021 Gazette 2021/03)**

(54) **PROCÉDÉ DE DÉTERMINATION DE L'ÉTAT DE CHARGE DES CELLULES D'UNE BATTERIE**

VERFAHREN ZUR BESTIMMUNG DES GESUNDHEITSZUSTANDS DER ZELLEN EINER BATTERIE

METHOD FOR DETERMINING THE STATE OF CHARGE OF THE CELLS OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.07.2019 FR 1908115**

(43) Date de publication de la demande:
**25.05.2022 Bulletin 2022/21**

(73) Titulaire: **Commissariat à l'Energie Atomique et aux Energies Alternatives
75015 Paris (FR)**

(72) Inventeur: **CROUZEVIALLE, Bruno
38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
DE-A1- 102013 217 752   FR-A1- 3 018 360
FR-A1- 3 054 669   US-A1- 2012 293 131
US-A1- 2014 184 169   US-A1- 2014 184 236

**Description**

La présente demande de brevet revendique la priorité de la demande de brevet français FR19/08115.

Domaine technique

La présente description concerne le domaine des batteries électriques de façon générale, et vise plus particulièrement la détermination de l'état de charge des cellules d'une batterie.

Technique antérieure

Une batterie électrique est un groupement de plusieurs cellules rechargeables reliées en série et/ou en parallèle entre deux noeuds ou bornes de fourniture de tension.

Dans certaines applications, on souhaite pouvoir estimer, pour chaque cellule d'une batterie, un indicateur représentatif de l'état de charge de la cellule, généralement appelé SOC, de l'anglais "State of Charge". A un instant donné, le SOC peut être défini comme étant le rapport de la quantité de charges restant dans la cellule, ou capacité résiduelle de la cellule (i.e. le nombre d'ampères-heure encore disponibles dans la cellule), sur la capacité totale de la batterie.

La connaissance du SOC de chaque cellule peut par exemple permettre d'identifier des cellules défectueuses pour les isoler ou les remplacer. En particulier, en cas de divergence importante d'état de charge entre différentes cellules à un instant donné, l'utilisateur peut être prévenu que certaines cellules sont peut-être défectueuses. La connaissance du SOC de chaque cellule peut par ailleurs être utile pour réaliser un tri des cellules dans des applications de recyclage de batteries électriques usagées.

La demande de brevet français FR3054669 précédemment déposée par le demandeur décrit un procédé de détermination de l'état de santé des cellules d'une batterie.

Résumé de l'invention

L'invention est exposée dans le jeu de revendications joint.

Un mode de réalisation prévoit un procédé de détermination, pour chaque cellule d'une batterie comportant une pluralité de cellules reliées en série, d'un indicateur QCi représentatif de la charge stockée dans la cellule, ce procédé comportant les étapes suivantes :

a) à l'issue d'une phase de décharge ou de recharge partielle de la batterie, mesurer la tension Ui aux bornes de chaque cellule de la batterie ;
b) calculer, pour chaque cellule, un coefficient d'interpolation Xi à partir d'une valeur C_rate représentative du régime de décharge ou de recharge de la batterie pendant ladite phase de décharge ou de recharge partielle, et des tensions Ui mesurées à l'étape a) ; et
c) déterminer, pour chaque cellule, à partir du coefficient d'interpolation Xi calculé pour la cellule à l'étape b) et d'une grandeur Qcm représentative de la charge stockée dans la batterie, ledit indicateur QCi représentatif de la charge stockée dans la cellule.

Pour chaque cellule, le coefficient d'interpolation Xi calculé à l'étape b) est fonction de la tension Ui de la cellule mesurée à l'étape a), de la valeur C_rate, d'une valeur Umin définie comme étant la tension la plus faible des tensions Ui mesurées à l'étape a), d'une valeur Umax définie comme étant la tension la plus élevée des tensions Ui mesurées à l'étape b), et d'une valeur Umoy définie comme étant la moyenne des tensions Ui mesurées à l'étape b).

Pour chaque cellule, le coefficient d'interpolation Xi calculé à l'étape b) est défini comme suit :

[Math. 1]

$$Xi = (K + B * D * C + B * D * E - B * A)/K$$

où A, B, C, D, E et K sont des paramètres définis comme suit :

[Math. 2]

$$K = (Umoy^2 * (1 + S * C\_rate))/(2 * C\_rate)$$

[Math. 3]

$$A = Umax - Ui$$

[Math. 4]

$$B = Ui - Umin$$

[Math. 5]

$$C = Ui/Umin$$

[Math. 6]

$$D = Ui/Umax$$

[Math. 7]

$$E = (Umax - Umin)/Ui$$

où S désigne le signe du courant de décharge ou de recharge appliqué à la batterie à l'étape a).

Selon un mode de réalisation de la présente invention, pour chaque cellule, à l'étape c), l'indicateur QCi est calculé selon la formule suivante :

[Math. 8]

$$QCi = Xi * Qcm$$

Selon un mode de réalisation de la présente invention, le procédé comporte en outre, après l'étape c), la fourniture, pour chaque cellule de la batterie, d'un indicateur SOCCi représentatif de l'état de charge de la cellule, calculé à partir de l'indicateur QCi calculé pour la cellule à l'étape c) et d'une grandeur Qtot représentative de la capacité de la batterie.

Selon un mode de réalisation de la présente invention, pour chaque cellule, l'indicateur SOCCi est défini comme suit :

[Math. 9]

$$SOCCi = QCi/Qtot$$

Selon un mode de réalisation de la présente invention, le procédé comprend en outre, avant l'étape a), une phase de détermination de la grandeur Qtot comprenant une étape de recharge résiduelle de la batterie jusqu'à son niveau de pleine charge suivie d'une étape de décharge complète de la batterie, ou une étape de décharge résiduelle de la batterie jusqu'à son niveau de pleine décharge suivie d'une étape de recharge complète de la batterie.

Un autre mode de réalisation prévoit un procédé de revalorisation de cellules de batteries usagées comportant une étape de diagnostic des cellules mettant en oeuvre un procédé tel que défini ci-dessus, suivie d'une étape de sélection de cellules dont l'indicateur QCi satisfait une condition prédéfinie.

Selon un mode de réalisation de la présente invention, le procédé comporte en outre une étape d'assemblage des cellules sélectionnées en une nouvelle batterie.

Un autre mode de réalisation prévoit un procédé de caractérisation d'une batterie électrique sur un banc de cyclage, comportant la mise en oeuvre d'un procédé tel que défini ci-dessus.

Brève description des dessins

Ces caractéristiques et avantages, ainsi que d'autres, seront exposés en détail dans la description suivante de modes de réalisation particuliers faite à titre non limitatif en relation avec la figure jointe :

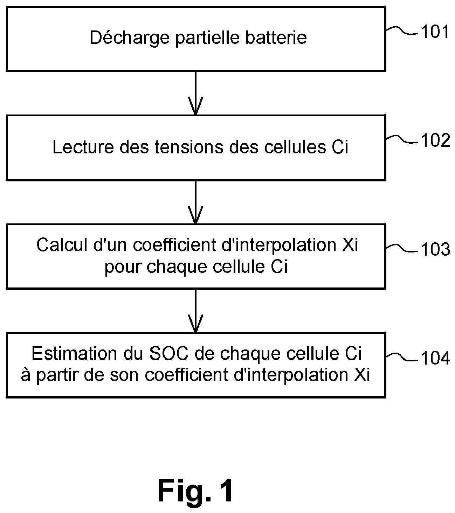

la figure 1 est un logigramme illustrant, sous forme de blocs, un exemple d'un procédé de détermination de l'état de charge des cellules d'une batterie selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites du SOC des cellules d'une batterie n'ont pas été détaillées. De plus, les circuits électroniques de mesure et de traitement utilisés pour mettre en oeuvre le procédé proposé de détermination du SOC des cellules d'une batterie n'ont pas été détaillés, la réalisation de tels circuits étant à la portée de l'homme du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

On s'intéresse ici plus particulièrement à la détermination du SOC des cellules d'une batterie comportant plusieurs cellules reliées en série entre une borne positive et une borne négative de la batterie. Les cellules de la batterie sont de préférence identiques aux dispersions de fabrication et de vieillissement près. Chaque cellule peut comporter une unique cellule élémentaire de type pile, accumulateur, etc., ou plusieurs cellules élémentaires reliées en série et/ou en parallèle entre une borne positive et une borne négative de la cellule. Les cellules élémentaires sont par exemple des cellules au lithium, par exemple des cellules de type lithium-ion, lithium-métal-polymère, etc. Plus généralement, les modes de réalisation décrits s'appliquent à toutes ou à la plupart des technologies de cellules élémentaires de batterie connues.

La figure 1 est un logigramme illustrant, sous forme de blocs, un exemple d'un procédé de détermination de l'état de charge des cellules d'une batterie selon un mode de réalisation.

On considère dans cet exemple une batterie (non représentée) comportant n cellules C1, ..., Cn reliées en série entre une borne positive et une borne négative de la batterie, avec n entier supérieur ou égal à 2, par exemple supérieur ou égal à 3.

Un outil de détermination de SOC (non représenté) est connecté à la batterie, cet outil comportant n capteurs de tension connectés respectivement aux bornes des n cellules Ci de la batterie, avec i entier allant de 1 à n. Chaque capteur de tension est adapté à mesurer la tension Ui aux bornes de la cellule Ci à laquelle il est associé. L'outil de détermination de SOC peut en outre comporter un compteur coulométrique ou un intégrateur de courant connecté à au moins une borne de la batterie, ou tout autre élément permettant de mesurer ou d'estimer la charge extraite de la batterie lors d'une phase de décharge de la batterie ou injectée dans la batterie lors d'une phase de recharge de la batterie. L'outil de détermination de SOC comporte en outre des moyens de mémorisation (mémoire, registre, etc.) d'au moins un jeu de n valeurs de tension Ui mesurées respectivement aux bornes des n cellules Ci de la batterie à un instant donné. L'outil de détermination de SOC peut en outre comporter une unité de traitement pouvant comporter un microprocesseur. En pratique, l'outil de détermination de SOC peut faire partie d'un dispositif électronique de gestion de la batterie intégré à la batterie, généralement désigné par le terme BMS, de l'anglais "Battery Management System", destiné à mettre en oeuvre des fonctions diverses telles que des fonctions d'équilibrage des cellules, des fonctions de protection, etc. En effet, les composants susmentionnés de l'outil de détermination de SOC sont des composants que l'on retrouve classiquement dans un dispositif de gestion de batterie de type BMS. A titre de variante, l'outil de détermination de SOC peut être un dispositif externe à la batterie, destiné à être connecté à la batterie lors d'une phase de détermination du SOC des cellules de la batterie. Dans une autre variante, l'outil de détermination de SOC peut être partiellement intégré à la batterie et partiellement externe à la batterie. Par exemple, les capteurs de tension de l'outil de détermination de SOC peuvent être internes à la batterie, et le dispositif de traitement mettant en oeuvre la méthode décrite à partir des valeurs de tension fournies par les capteurs peut être externe à la batterie. L'outil de détermination de SOC est configuré pour mettre en oeuvre le procédé de la figure 1 de détermination de l'état de charge des cellules de la batterie.

Le procédé de la figure 1 comprend une étape 101 au cours de laquelle la batterie est soumise à une décharge partielle, par exemple à courant constant et à température ambiante constante.

A la fin de la phase de décharge partielle, lors d'une étape 102, l'outil de détermination de SOC lit et mémorise les tensions Ui aux bornes des différentes cellules de la batterie. Les n tensions Ui sont par exemple lues en parallèle (c'est-à-dire simultanément) et mémorisées dans un registre ou une mémoire de l'outil de détermination de SOC. Lors de l'étape 102, l'outil de détermination de SOC détermine et mémorise en outre une grandeur Qcm représentative de la quantité de charge restant dans la batterie à la fin de la phase de décharge partielle de l'étape 101. A titre d'exemple, l'outil de détermination de SOC est configuré pour mesurer toutes les variations de charge de la batterie lors des phases de décharge ou de recharge de la batterie, ce qui lui permet de connaître la valeur Qcm.

Lors d'une étape 103, pour chacune des cellules Ci de la batterie, l'outil de détermination de SOC calcule un coefficient d'interpolation Xi spécifique à la cellule, fonction de la tension Ui de la cellule mémorisée à l'étape 102, du régime de décharge C_rate de la batterie pendant la phase de décharge partielle de l'étape 101 (courant de décharge appliqué à la batterie pendant l'étape 101), ainsi que des tensions aux bornes d'une ou plusieurs autres cellules de la batterie mémorisées à l'étape 102.

Dans cet exemple, le coefficient d'interpolation Xi est fonction de la tension Ui de la cellule mémorisée à l'étape 102, du régime de décharge C_rate des cellules de la batterie pendant la phase de décharge partielle de l'étape 101, d'une valeur Umin définie comme étant la tension la plus faible du jeu de tensions Ui mémorisé à l'étape 102, d'une valeur Umax définie comme étant la tension la plus élevée du jeu de tensions Ui mémorisé à l'étape 102, et d'une valeur Umoy définie comme étant la moyenne des tensions Ui mémorisées à l'étape 102.

Par régime de décharge C_rate, on entend ici le rapport entre le courant de décharge Idch de la batterie, en ampères, pendant la phase de décharge partielle de l'étape 101 (ou la valeur moyenne du courant de décharge dans le cas où le courant de décharge n'est pas constant pendant la phase de décharge 101) et la capacité initiale Qinit d'une cellule élémentaire de la batterie, c'est-à-dire sa capacité à l'état neuf, en ampère-heure (par exemple la capacité nominale de la cellule telle que fournie par le fabricant).

A titre d'exemple, la durée de la phase de décharge partielle peut être comprise entre quelques secondes et quelques minutes, par exemple entre 1 seconde et 10 minutes. Lorsque la durée de la phase de décharge partielle est importante, par exemple supérieure à 10 secondes, et que le courant de décharge Idch de la batterie pendant la phase de décharge partielle présente des variations importantes, par exemple supérieures à 20 pourcents, on se basera de préférence, pour le calcul du régime de décharge C_rate, sur la valeur du courant de décharge Idch mesurée à la fin de la phase de décharge partielle, et non pas sur une valeur moyenne du courant de décharge Idch pendant la phase de décharge partielle.

Dans cet exemple, le coefficient d'interpolation Xi est défini comme suit :

[Math. 10]

$$Xi = (K + B * D * C + B * D * E - B * A)/K$$

où A, B, C, D, E et K sont des paramètres définis comme suit :

[Math. 11]

$$K = (Umoy^2 * (1 + C\_rate))/(2 * C\_rate)$$

[Math. 12]

$$A = Umax - Ui$$

[Math. 13]

$$B = Ui - Umin$$

[Math. 14]

$$C = Ui/Umin$$

[Math. 15]

$$D = Ui/Umax$$

[Math. 16]

$$E = (Umax - Umin)/Ui$$

Lors d'une étape 104, pour chaque cellule Ci de la batterie, une fois le coefficient d'interpolation Xi de la cellule déterminé, l'outil de détermination de SOC calcule une valeur QCi représentative de la quantité de charge restant dans la cellule à partir du coefficient d'interpolation Xi de la cellule, selon la formule suivante :

[Math. 17]

$$QCi = Xi * Qcm$$

Connaissant la quantité de charge QCi disponible dans la cellule, son SOC peut être calculé par l'outil de détermination de SOC, par exemple selon la formule suivante :

[Math. 18]

$$SOCCi = QCi/Qtot$$

où Qtot désigne la capacité de la batterie.

La capacité Qtot peut être déterminée lors d'une phase préalable, non représentée sur la figure 1. A titre d'exemple, la détermination de la capacité Qtot peut comprendre une phase de recharge résiduelle de la batterie jusqu'à son niveau de pleine charge, suivie d'une phase de décharge complète de la batterie. L'outil de détermination de SOC mesure alors la valeur de la charge Q extraite de la batterie entre le début et la fin de la phase de décharge complète, qui définit la capacité Qtot de la batterie. A titre de variante, la détermination de la capacité Qtot peut comprendre une phase de décharge résiduelle de la batterie jusqu'à son niveau de décharge complète, suivie d'une phase de recharge complète de la batterie jusqu'à son niveau de pleine charge. L'outil de détermination de SOC mesure alors la valeur de la charge Q injectée dans la batterie entre le début et la fin de la phase de recharge complète, qui définit la capacité Qtot de la batterie. La capacité Qtot n'a pas besoin d'être actualisée à chaque itération du procédé de la figure 1. Toutefois, la capacité Qtot est de préférence régulièrement mesurée de façon à tenir compte du vieillissement de la batterie. A titre de variante, la capacité Qtot considérée dans le procédé de la figure 1 est une valeur fixe constante, correspondant par exemple à la valeur de capacité fournie par le constructeur de la batterie.

Un avantage du procédé décrit en relation avec la figure 1 est qu'il permet d'estimer individuellement l'état de charge des différentes cellules d'une batterie à partir d'une simple mesure des tensions aux bornes des différentes cellules à l'issue d'une phase de décharge partielle de la batterie, sans avoir à acquérir et enregistrer les courbes de décharge des différentes cellules de la batterie pendant la phase de décharge et sans avoir à faire appel à des bibliothèques de courbes de caractérisation.

A titre d'exemple, le SOC de chacune des cellules Ci peut être estimé périodiquement, par le procédé de la figure 1, tout au long d'une phase de décharge complète de la batterie, par exemple à courant constant et à température ambiante constante. Ceci permet d'obtenir, pour chaque cellule Ci, une courbe représentative de l'évolution du SOC de la cellule tout au long de la phase de décharge. Une telle courbe peut par exemple être utilisée pour identifier d'éventuels écarts de comportement entre les différentes cellules, et ainsi identifier d'éventuelles cellules défaillantes.

Ce procédé peut par exemple être mis en oeuvre par un dispositif de gestion intégré à la batterie, pendant le cycle de vie normal de la batterie, pour surveiller l'état des différentes cellules de la batterie, par exemple en vue de planifier d'éventuelles opérations de maintenance de la batterie, pour optimiser l'utilisation de la batterie, ou pour prévenir un éventuel disfonctionnement.

Une autre application de la méthode proposée concerne le diagnostic des cellules d'une batterie usagée en vue de leur revalorisation. A titre d'exemple, une fois les indicateurs d'état de charge des différentes cellules déterminés par la méthode proposée, on peut prévoir de prélever les cellules dont le SOC satisfait une condition prédéfinie, par exemple les cellules dont le SOC est supérieur à un seuil, par exemple en vue de les réassembler dans une nouvelle batterie. Les autres cellules sont par exemple recyclées par récupération des métaux les constituant. On notera que, si les batteries usagées à revaloriser ne présentent pas une architecture série, ces dernières peuvent être démontées et leurs cellules réassemblées en série pour mettre en oeuvre la méthode de sélection décrite ci-dessus.

Une autre application de la méthode proposée concerne la caractérisation de batteries sur des bancs de cyclage lors de leur conception. La méthode proposée peut être appliquée sur un banc de cyclage pour suivre l'évolution et la dispersion du SoC des cellules lors des essais de caractérisation.

Bien que l'on ait décrit ci-dessus, en relation avec la figure 1, une méthode de détermination du SOC des cellules mise en oeuvre à partir d'une phase de décharge partielle de la batterie, une méthode similaire peut être mise en oeuvre à partir d'une recharge partielle de la batterie. Dans ce cas, le procédé est identique à ce qui a été décrit ci-dessus, à la différence près que la définition du coefficient K (équation Math 11 ci-dessus) est modifiée comme suit :

[Math. 19]

$$K = (Umoy^2 * (1 - C\_rate))/(2 * C\_rate)$$

Autrement dit, la définition du coefficient K peut être généralisée comme suit :

[Math. 20]

$$K = (Umoy^2 * (1 + S * C\_rate))/(2 * C\_rate)$$

où S désigne le signe du courant circulant dans la batterie au moment de la mesure des tensions Ui des cellules de la batterie (i.e. à la fin de l'étape 101).

Des modes de réalisation particuliers ont été décrits. Diverses variantes et modifications apparaîtront à l'homme de l'art. En particulier, les modes de réalisation décrits ne se limitent pas à l'exemple particulier de définition de l'estimateur d'état de charge de l'équation Math 18. A titre de variante, pour chaque cellule Ci, l'estimateur calculé à l'étape 104 peut être tout estimateur représentatif, directement ou indirectement, de l'état de charge de la cellule, par exemple un estimateur d'état de décharge (SOD, de l'anglais "State of Discharge") ou de profondeur de décharge (DOD, de l'anglais "Depth of Discharge"), ou encore un estimateur d'état d'énergie (SOE, de l'anglais "State of Energy").

## Revendications

1. Procédé de détermination, pour chaque cellule d'une batterie comportant une pluralité de cellules (Ci) reliées en série, d'un indicateur QCi représentatif de la charge stockée dans la cellule (Ci), ce procédé comportant les étapes suivantes :

   a) à l'issue d'une phase (101) de décharge ou de recharge partielle de la batterie, mesurer (102) la tension Ui aux bornes de chaque cellule (Ci) de la batterie ;
   b) calculer (103), pour chaque cellule (Ci), un coefficient | d'interpolation Xi à partir d'une valeur C_rate représentative du régime de décharge ou de recharge de la batterie pendant ladite phase (101) de décharge ou de recharge partielle, et des tensions Ui mesurées à l'étape a) ; et
   c) déterminer (104), pour chaque cellule (Ci), à partir du coefficient d'interpolation Xi calculé pour la cellule à l'étape b) et d'une grandeur Qcm représentative de la charge stockée dans la batterie, ledit indicateur QCi représentatif de la charge stockée dans la cellule (Ci), dans lequel, pour chaque cellule (Ci), le coefficient d'interpolation Xi calculé à l'étape b) est fonction de la tension Ui de la cellule mesurée à l'étape a), de la valeur C_rate, d'une valeur Umin définie comme étant la tension la plus faible des tensions Ui mesurées à l'étape a), d'une valeur Umax définie comme étant la tension la plus élevée des tensions Ui mesurées à l'étape b), et d'une valeur Umoy définie comme étant la moyenne des tensions Ui mesurées à l'étape b), et dans lequel, pour chaque cellule (Ci), le coefficient d'interpolation Xi calculé à l'étape b) est défini comme suit :

$$Xi = (K + B * D * C + B * D * E - B * A)/K$$

où A, B, C, D, E et K sont des paramètres définis comme suit :

$$K = (Umoy^2 * (1 + S * C\_rate))/(2 * C\_rate)$$

$$A = Umax - Ui$$

$$B = Ui - Umin$$

$$C = Ui/Umin$$

$$D = Ui/Umax$$

$$E = (Umax - Umin)/Ui$$

où S désigne le signe du courant de décharge ou de recharge appliqué à la batterie à l'étape a).

2. Procédé selon la revendication 1, dans lequel, pour chaque cellule (Ci), à l'étape c), l'indicateur QCi est calculé selon la formule suivante :

$$QCi = Xi * Qcm$$

3. Procédé selon la revendication 1 ou 2, comportant en outre, après l'étape c), la fourniture, pour chaque cellule (Ci) de la batterie, d'un indicateur SOCCi représentatif de l'état de charge de la cellule (Ci), calculé à partir de l'indicateur QCi calculé pour la cellule à l'étape c) et d'une grandeur Qtot représentative de la capacité de la batterie.

4. Procédé selon la revendication 3, dans lequel, pour chaque cellule, l'indicateur SOCCi est défini comme suit :

$$SOCCi = QCi/Qtot$$

5. Procédé selon la revendication 3 ou 4, comportant en outre, avant l'étape a), une phase de détermination de la grandeur Qtot comprenant une étape de recharge résiduelle de la batterie jusqu'à son niveau de pleine charge suivie d'une étape de décharge complète de la batterie, ou une étape de décharge résiduelle de la batterie jusqu'à son niveau de pleine décharge suivie d'une étape de recharge complète de la batterie.

6. Procédé de revalorisation de cellules de batteries usagées comportant une étape de diagnostic des cellules mettant en oeuvre un procédé selon l'une quelconque des revendications 1 à 5, suivie d'une étape de sélection de cellules (Ci) dont l'indicateur QCi satisfait une condition prédéfinie.

7. Procédé selon la revendication 6, comportant en outre une étape d'assemblage des cellules (Ci) sélectionnées en une nouvelle batterie.

8. Procédé de caractérisation d'une batterie électrique sur un banc de cyclage, comportant la mise en oeuvre du procédé selon l'une quelconque des revendications 1 à 5.

**Patentansprüche**

1. Verfahren zum Bestimmen, für jede Zelle einer Batterie, die eine Vielzahl von in Reihe geschalteten Zellen (Ci) aufweist, eines Indikators QCi, der für die Ladung repräsentativ ist, die in der Zelle (Ci) gespeichert ist, wobei dieses Verfahren die folgenden Schritte aufweist:

a) am Ende einer Phase (101) der teilweisen Entladung oder Aufladung der Batterie, Messen (102) der Spannung Ui über jeder Zelle (Ci) der Batterie;
b) Berechnen (103), für jede Zelle (Ci), eines Interpolationskoeffizienten Xi ausgehend von einem Wert C_rate, der repräsentativ für den Entlade- oder Aufladezustand der Batterie während der Phase (101) der teilweisen Entladung oder Aufladung ist, und der Spannungen Ui, die in Schritt a) gemessen wurden; und
c) Bestimmen (104), für jede Zelle (Ci), ausgehend von dem Interpolationskoeffizienten Xi, der für die Zelle in Schritt b) berechnet wurde, und von einer Größe Qcm, die repräsentativ für die Ladung ist, die in der Batterie gespeichert ist, und zwar des Indikators QCi, der repräsentativ für die Ladung ist, die in der Zelle (Ci) gespeichert ist,

wobei für jede Zelle (Ci) der Interpolationskoeffizient Xi, der in Schritt b) berechnet wurde, eine Funktion ist der Spannung Ui der Zelle, die in Schritt a) gemessen wurde, des Wertes C_rate, eines Wertes Um in, der definiert ist als der niedrigste Wert der Spannungen Ui, die in Schritt a) gemessen wurden, einem Umax-Wert, der definiert ist als die höchste Spannung der Spannungen Ui, die in Schritt b) gemessen wurden, und einem Wert Umoy, der definiert ist als der Durchschnitt der Spannungen Ui, die in Schritt b) gemessen wurden, und

wobei für jede Zelle (Ci) der Interpolationskoeffizient Xi, der in Schritt b) berechnet wurde, wie folgt definiert ist:

$$Xi = (K + B * D * C + B * D * E - B - A)/K$$

wobei A, B, C, D, E und K Parameter sind, die wie folgt definiert sind:

$$K = \left(Umoy^2 * (1 + S * C\_rate)\right)/(2 * C\_rate)$$

$$A = Umax - Ui$$

$$B = Ui - Umin$$

$$C = Ui/Umin$$

$$D = Ui/Umax$$

$$E = (Umax - Umin)/Ui$$

wobei S das Vorzeichen des Entlade- oder Ladestroms bezeichnet, der in Schritt a) an die Batterie angelegt wurde.

2. Verfahren nach Anspruch 1, wobei für jede Zelle (Ci) in Schritt c) der Indikator QCi nach der folgenden Formel berechnet wird:

$$QCi = Xi * Qcm$$

3. Verfahren nach Anspruch 1 oder 2, das ferner, nach Schritt c), für jede Zelle (Ci) der Batterie, die Lieferung eines Indikators SOCCi aufweist, der für den Ladezustand der Zelle (Ci) repräsentativ ist und ausgehend von dem Indikator QCi, der für die Zelle in Schritt c) berechnet wurde, und von einer Größe Qtot, die für die Kapazität der Batterie repräsentativ ist, berechnet wird.

4. Verfahren nach Anspruch 3, wobei für jede Zelle der Indikator SocCi wie folgt definiert ist:

$$SOCCi = QCi/Qtot$$

5. Verfahren nach Anspruch 3 oder 4, das ferner, vor Schritt a), eine Phase der Bestimmung der Größe Qtot aufweist, aufweisend einen Schritt der Restaufladung der Batterie bis zu ihrem Vollladungsniveau, gefolgt von einem Schritt der vollständigen Entladung der Batterie, oder einen Schritt der Restentladung der Batterie bis zu ihrem Vollentladungsniveau, gefolgt von einem Schritt der vollständigen Aufladung der Batterie.

6. Verfahren zur Wiederverwertung von gebrauchten Batteriezellen, das einen Schritt zur Diagnose der Zellen aufweist, bei dem ein Verfahren nach einem der Ansprüche 1 bis 5 umgesetzt wird, gefolgt von einem Schritt zur Auswahl von Zellen (Ci) mit einem Indikator QCi, der eine vordefinierte Bedingung erfüllt.

7. Verfahren nach Anspruch 6, das zusätzlich einen Schritt des Zusammenbaus der ausgewählten Zellen (Ci) zu einer neuen Batterie aufweist.

8. Verfahren zur Charakterisierung einer elektrischen Batterie auf einer zyklischen Prüfbank, aufweisend die Umsetzung des Verfahrens nach einem der Ansprüche 1 bis 5.

**Claims**

1. Method of determining, for each cell of a battery comprising a plurality of series-coupled cells (Ci), of an indicator QCi representative of the charge stored in the cell (Ci), this method comprising the steps of:

   a) at the end of a phase (101) of partial discharge or charge of the battery, measuring (102) the voltage Ui across each cell (Ci) of the battery;
   b) calculating (103), for each cell (Ci), an interpolation coefficient Xi from a value C_rate representative of the battery discharge or charge rate during said partial discharge or charge phase (101), and from the voltages Ui measured at step a); and
   c) determining (104), for each cell (Ci), from the interpolation coefficient Xi calculated for the cell at step b) and from a quantity Qcm representative of the charge stored in the battery, said indicator QCi representative of the charge stored in the cell (Ci),
   wherein for each cell (Ci), the interpolation coefficient Xi calculated at step b) is a function of the voltage Ui of the cell measured at step a), of value C_rate, of a value Umin defined as being the lowest value of the voltages Ui measured at step a), of a value Umax defined as being the highest voltage of the voltages Ui measured at step b), and of a value Umoy defined as being the average of the voltages Ui measured at step b),
   and wherein, for each cell (Ci), the interpolation coefficient Xi calculated at step b) is defined as follows:

$$Xi = (K + B * D * C + B * D * E - B * A)/K$$

   where A, B, C, D, E, and K are parameters defined as follows:

$$K = (Umoy^2 * (1 + S * C\_rate))/(2 * C\_rate)$$

$$A = Umax - Ui$$

$$B = Ui - Umin$$

$$C = Ui/Umin$$

$$D = Ui/Umax$$

$$E = (Umax - Umin)/Ui$$

   where S designates the sign of the discharge or charge current applied to the battery at step a).

2. Method according to claim 1, wherein, for each cell (Ci), at step c), indicator QCi is calculated according to the following formula:

$$QCi = Xi * Qcm$$

3. Method according to claim 1 or 2, further comprising, after step c), the provision, for each cell (Ci) of the battery, of an indicator SOCCi representative of the state of charge of the cell (Ci), calculated from the indicator QCi calculated for the cell at step c) and from a quantity Qtot representative of the battery capacity.

4. Method according to claim 3, wherein, for each cell, indicator SOCCi is defined as follows:

$$SOCCi = QCi/Qtot$$

5. Method according to claim 3 or 4, further comprising, before step a), a phase of determination of quantity Qtot comprising a step of residual charge of the battery up to its full charge level followed by a step of full discharge of the battery, or a step of residual discharge of the battery down to its full discharge level followed by a step of full charge of the battery.

6. Method of recycling used battery cells comprising a step of diagnosis of the cells implementing a method according to any of claims 1 to 5, followed by a step of selection of cells (Ci) having an indicator QCi satisfying a predefined condition.

7. Method according to claim 6, further comprising a step of assembly of the selected cells (Ci) in a new battery.

8. Method of characterization of an electric battery on a cycling test bench, comprising the implementation of the method according to any of claims 1 to 5.

```
┌─────────────────────────────────────────┐
│        Décharge partielle batterie        │───101
└─────────────────────────────────────────┘
                    │
                    ▼
┌─────────────────────────────────────────┐
│      Lecture des tensions des cellules Ci │───102
└─────────────────────────────────────────┘
                    │
                    ▼
┌─────────────────────────────────────────┐
│    Calcul d'un coefficient d'interpolation Xi │───103
│         pour chaque cellule Ci            │
└─────────────────────────────────────────┘
                    │
                    ▼
┌─────────────────────────────────────────┐
│   Estimation du SOC de chaque cellule Ci  │───104
│   à partir de son coefficient d'interpolation Xi │
└─────────────────────────────────────────┘
```

# Fig. 1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1908115
- FR 3054669